# EUROPEAN PATENT SPECIFICATION

(11) **EP 2 584 703 B1**
(45) Date of publication and mention of the grant of the patent: **22.06.2016**
(21) Application number: 12188767.3
(22) Date of filing: 17.10.2012
(51) Int. Cl.: H03K 17/94, G01V 8/20

(54) **Photoelectric switch**
Photoelektrischer Schalter
Commutateur photoélectrique

(30) Priority: 21.10.2011 JP 2011232272
(43) Date of publication of application: 24.04.2013
(73) Proprietor: Azbil Corporation, Chiyoda-ku Tokyo 100-6419 (JP)
(72) Inventor: Hatanaka, Hiroshi, Tokyo 100-6419 (JP); Nakao, Takashi, Tokyo 100-6419 (JP); Sasaki, Hiroshi, Tokyo 100-6419 (JP); Suzuki, Shinichiro, Tokyo 100-6419 (JP)
(74) Representative: Tischner, Oliver

(56) References cited:
- EP-A1- 2 230 538
- DE-U1-202008 014 137
- GB-A- 2 278 916

## Description

### Field of Technology

The present invention relates to a photoelectric switch for detecting a detection object based on a change in a detected luminescent flux quantity.

### Background

GB 2 278 916 A concerns a system for detecting and assessing the nature and position of an object passing through, and thus interrupting, one or more beams, which system comprises means arranged to generate a matrix of beams intersecting each other, to form a net-like pattern of beams, and means arranged to generate information relating to any beam(s) interrupted by an intruding object and to supply such information to an analyser arranged to determine therefrom, to a suitable approximation, both the nature and position of the object which has interrupted the beam(s).

EP 2 230 538 A1 discloses a method for operating a sensor having a light array comprising a plurality of emitters and a plurality of light receivers.

A transmissive photoelectric switch is provided with a set having a transmitter and a detector, to detect whether or not there is a change in a luminescent flux quantity depending on whether or not there is a blockage, due to a detection object when it passes through a light path. (See, for example, Japanese Unexamined Patent Application Publication H5-175817.) FIG. 5 is a diagram illustrating an example of a configuration when using a transmissive photoelectric switch in a state wherein three units are used together, where transmitters 100A through 100C are disposed on one side of a detecting region through which a detection object will pass, and detectors 200A through 200C are disposed on the other side. In this example, the transmitter 100A and the detector 200A form a pair, the transmitter 100B and the detector 200B form a pair, and the transmitter 100C and the detector 200C form a pair, where, for example, the detector 200A reacts only to a light signal from the transmitter 100A, and it is undesirable for it to react to light signals from the transmitters 100B and 100C. However, there is no exchange of information aside from light signals between a paired transmitter and detector, and thus it has not been possible for a detector to discern which transmitter is the source of a light signal that is detected.

Because of this, conventionally the transmitters and detectors have been disclosed in mutually differing configurations (zigzag configurations), or optical polarizing filters have been attached to the detectors to eliminate light from adjacent transmitters.

### Summary

Because conventional photoelectric switches have been structured as set forth above, in the zigzag configuration transmitters and detectors are each disposed on both sides of the detecting region, and thus there are problems in that the wiring from the controlling device is long, and problems with the occurrence of interference due to light that is reflected from the detection object. When a light polarizing filter is used, it is possible to cut out the light from an adjacent detector by attaching the optical polarizing filters of so that the angles of polarization are orthogonal, but because the detected luminescent flux quantity is reduced to no more than half, there is a reduction in the detection distance.

Examples of the present invention solve problems such as set forth above, and the object thereof is to provide a photoelectric switch able to evaluate accurately whether or not there is an incident-light state or a blocked-light state, even given mutual interference when using a plurality of photoelectric switches disposed together.

A photoelectric switch according to the present invention includes the features according to claim 1.

In the photoelectric switch according to the invention set forth in another example, the transmitter has a modulating portion for modulating, at a specific frequency, the projected light of the pulse width according to the specific light projecting pattern; and the detector has: a band pass filter portion for extracting, from a detected light signal, a signal using, as the center frequency, the modulating frequency used by the modulating portion; a detecting portion for rectifying the signal extracted by the band-pass filter portion; a low-pass filter portion set to a frequency characteristic so as to reduce, to a prescribed level, the frequency component that is superimposed on the signal through the modulation, in the signal that is rectified by the detecting portion; and a discriminating portion for outputting a detected light pulse by discriminating, at a prescribed threshold level, the signal extracted by the low-pass filter portion.

A photoelectric switch as set forth in a further example of the present invention has a pattern selecting portion for receiving an instruction from the outside to select a specific light projecting pattern from a plurality of light projecting patterns.

In the semiconductor device according to the invention set forth in a yet further example, the modulating portion modulates the projected light with a modulating period wherein there is a high level interval of approximately 1.0 µs and a low level interval of approximately 1.5 µs.

Examples of the present invention enables proper evaluation as to whether there is an incident-light state or a blocked-light state, even if there is mutual interference when a plurality of photoelectric switches are used together, through evaluating whether or not there is locally-emitted light, through evaluating whether or not a pulse width of a detected light pulse, produced by a detector, is essentially the same as a projected light pulse width of a light projecting pattern defined in accordance with the transmitter.

Another example of the present invention enables detection of a difference in a projected light pulse width from the transmitter side as a difference in a detected light pulse width on the detector side, through performing a low-pass filtering process that reduces, to a prescribed level, a frequency component that is superimposed on the signal, through the ability to cause the amplitude of the signal for which a band-pass filtering process is performed to be essentially identical even when there is a change in the projected light pulse width in accordance with a specific light projecting pattern, because the projected light pulse is modulated and the modulating frequency is used as the central frequency on the detector side to perform the band-pass filtering process.

The further example enables the prevention of an incorrect evaluation of whether there is an incident-light state or a blocked-light state when, even if there is an evaluation error as to whether there is light from mutual interference or locally-emitted light, the frequency of occurrence thereof is low, because the evaluation as to whether or not there is a detection object is made based on a count value that rises in accordance with the evaluation result by the pulse width evaluating portion. Because of this, it is possible to further reduce the incorrect evaluation of the incident-light/blocked-light status through selecting a projected light period to set a light projecting pattern so as to reduce the frequency of an evaluation error regarding whether or not there is locally-emitted light.

A yet further example of the present invention enables an increase in generalizability and extendability through enabling the user to freely install photoelectric switches for use together, through selecting the light projecting patterns through the receipt of instructions from the outside.

Another example according to the present invention makes it possible to secure an adequate signal level while reducing the effects of interference light through high-frequency modulation with a high level interval of approximately 1.0 µs and a low level interval of approximately 1.5 µs.

According to an embodiment, a transmitter 10 projects light in accordance with a specific light projecting pattern, selected by a pattern selecting portion 11, of three light projecting patterns A through C having mutually differing projected light periods and projected light pulse widths. A pulse width evaluating circuit 30 of a detector 20 detects, as a difference in pulse width of a detected light signal, the difference in the projected light pulse width of the light projecting pattern, based on the same light projecting pattern pulse width information as the transmitter 10, selected by a pattern selecting portion 21, to identify locally-emitted light versus interference light.

### Brief Explanation of the Drawings

FIG. 1 is a block diagram illustrating a structure of a photoelectric switch according to an example according to the present invention.
FIG. 2 is a graph for explaining three types of light projecting patterns for the photoelectric switch according to the example according to the present invention.
FIG. 3 is a graph illustrating an example of a detected light signal in accordance with a light projecting pattern of the photoelectric switch according to example according to the present invention.
FIG. 4 is a graph illustrating an example of operation of the photoelectric switch according to the example according to the present invention.

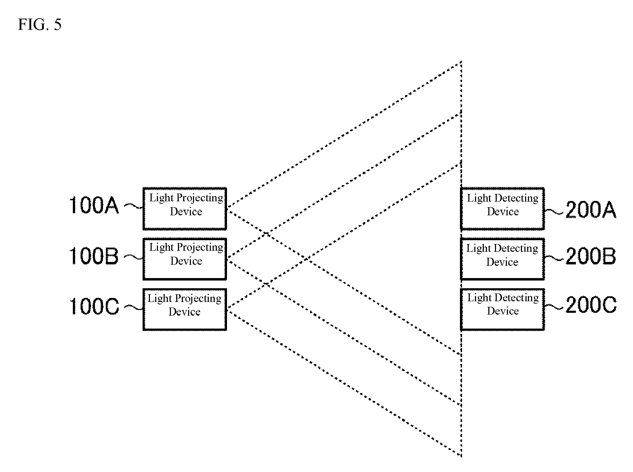

FIG. 5 is a diagram illustrating an example of a configuration when using three transmissive photoelectric switches in a state wherein they are installed together.

### Detailed Description

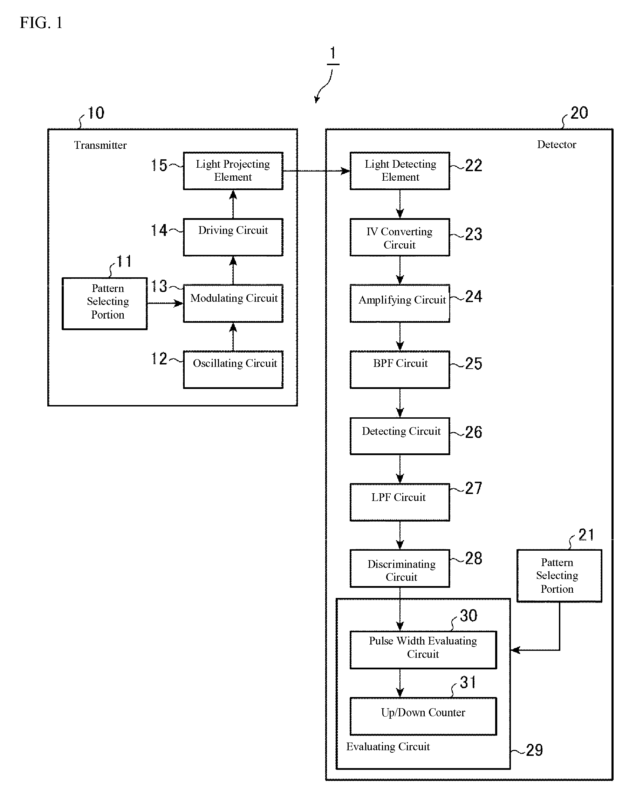

The photoelectric switch 1 illustrated in FIG. 1 is a transmissive photoelectric switch comprising a transmitter 10 and a detector 20 that are installed in a state wherein they are mutually facing with a detecting region therebetween, where the detector 20 evaluates whether or not there is a detection object in the detecting region, based on a change in the luminescent flux quantity that is incident from the detecting region.

In an example, a configuration is explained envisioning a case wherein the photoelectric switches 1 are used with a maximum of three units installed together. The three photoelectric switches 1 (differentiated here as photoelectric switches 1A through 1 C) are structured from three transmitters 10 having different projected light pulse frequencies and pulse widths, and three detectors 20 that discriminate between locally-emitted light and interference light based on the frequencies and pulse widths of the detected light. Here locally-emitted light refers to light that is detected by the detector 20 of the photoelectric switch 1A from the transmitter 10 of the same photoelectric switch 1A. Interference light refers to light that is detected by the detector of photoelectric switch 1A from a photoelectric switch 1B or 1C other than the photoelectric switch 1A.

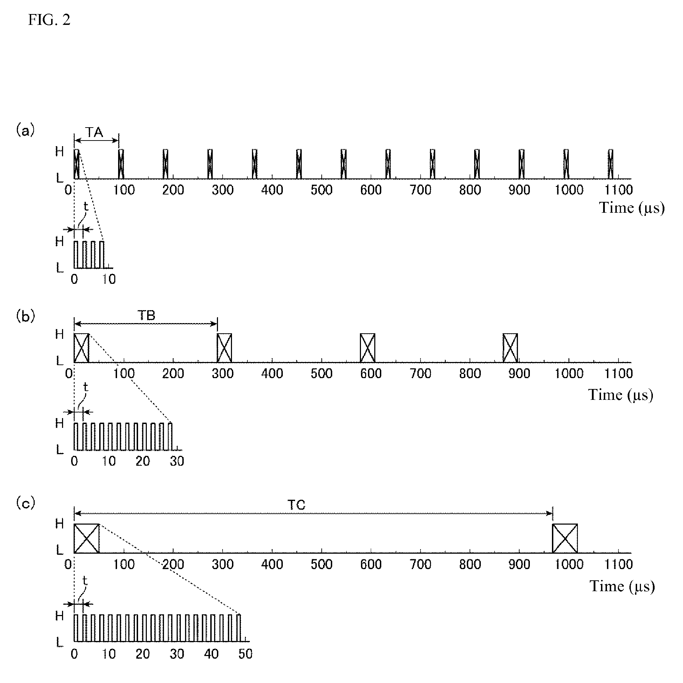

FIG. 2 illustrates light projecting patterns A through C. A projected light pulse comprises a pulse train that has undergone high-frequency modulation at a modulating period t = 2.5 µs (modulating frequency = 400 kHz), in common for the light projecting patterns A through C. This modulating period t is structured from a high level (H) interval of 1.0 µs and a low level (L) interval of 1.5 µs. The light projecting pattern A illustrated in FIG. 2 (a) is pulses of 4 trains wherein a projected light pulse with a projected light period of TA = 90 µs and a pulse width of 8.5 µs has undergone high-frequency modulation. The light projecting pattern B illustrated in FIG. 2 (b) is pulses of 12 trains wherein a projected light pulse with a projected light period of TB = 288 µs and a pulse width of 28.5 µs has undergone high-frequency modulation. The light projecting pattern C illustrated in FIG. 2 (c) is pulses of 20 trains wherein a projected light pulse with a projected light period of TC = 972 µs and a pulse width of 48.5 µs has undergone high-frequency modulation.

Here the H interval and the L interval of the modulating period t preferably is set in consideration of the state at the time of mutual interference and the signal level of the detected light signal. In this first form of embodiment, with the modulating period t, if the H interval were longer than 1.0 µs, then the influence of the interference light would be larger, and if shorter than this, then the signal level would be reduced, which would cause a worsening in the signal-to-noise ratio (S/N ratio), and thus the H interval is set to 1.0 µs (although this may be given some degree of range therefrom), and the L interval is set to 1.5 µs (although this may be given some range therefrom).

In the transmitter 10, information for the projected light periods and the projected light pulse widths that define the aforementioned light projecting patterns A through C is stored in advance in the pattern selecting portion 11. Given this, the pattern selecting portion 11 that has received, from the outside, an input for selecting one of the light projecting patterns A through C notifies the modulating circuit 13 of the light projecting pattern that has been selected. In this first form of embodiment, it is assumed that the light projecting patterns A is selected by the photoelectric switch 1A, the light projecting pattern B is selected by the photoelectric switch 1B, and the light projecting pattern 1C is selected by the photoelectric switch 1C.

The modulating circuit 13 modulates a constant-period clock signal, produced by an oscillating circuit 12, to the light projecting pattern that is specified by the pattern selecting portion 11. Note that the modulating frequency need not be limited 400 kHz, insofar as it is a frequency that is sufficiently higher than the frequency of the external noise light and noise that can be anticipated. A driving circuit 14 provides, to a light projecting element 15, a pulse current of the light projecting pattern that is outputted from the modulating circuit 13. Given this, the light projecting element 15, which is structured from an LED (a light-emitting diode), or the like, projects light toward the detecting region.

Information regarding the projected light periods, the projected light pulse widths, and the detected light pulse width evaluation conditions corresponding to the aforementioned light projecting patterns A through C is also recorded in the pattern selecting portion 21 of the detector 20. The details of each of these information are described below. Given this, the pattern selecting portion 21 that has received, from the outside, an input for selecting one of the light projecting patterns A through C notifies the evaluating circuit 29 of the detected light pulse width evaluating conditions and projected light period, depending on the selected light projecting pattern. In order to differentiate between locally-emitted light and interference light it is necessary to use the same light projecting pattern in both of the paired transmitter 10 and detector 20, and thus the light projecting pattern A is selected in the detector 20 of the photoelectric switch 1A, the light projecting pattern B is selected in the detector 20 of the photoelectric switch 1B, and the light projecting pattern C is selected in the detector 20 of the photoelectric switch 1C.

A light detecting element 22 is structured from a photodiode, or the like, to detect light from the direction of the detecting region, to output an electric current value of a level that is in accordance with the detected luminescent flux quantity. The output electric current from the light detecting element 22 undergoes current-voltage conversion in an IV converting circuit 23, and is amplified by an amplifying circuit 24. A modulating frequency that is the same as that of the modulating circuit 13 of the transmitter 10 (which, in this case, is 400 kHz) is also set in the BPF (band-pass filter) circuit 25, where this modulating frequency is used as the central frequency for the passing band in performing a filtering process on the output signal from the amplifying circuit 24. Doing so eliminates the external noise that derives from, for example, inverter-type fluorescent lights that emit light of a frequency of, for example, about 100 kHz. Moreover, the output signal from the BPF circuit 25 undergoes rectification in a demodulating circuit 26. An LPF circuit 27 performs a filtering process on the output signal from the demodulating circuit 26 so as to reduce, to the required level, the high-frequency component that is superimposed, through high-frequency modulation, by the transmitter 10 side. Doing so eliminates the high-frequency component, making it possible to demodulate the detected signal to a signal having a bandwidth in accordance with the projected light pulse width of the locally-emitted light.

A discriminating circuit 28 compares, to a prescribed threshold value that has been set in advance, the detected light signal level that is outputted from the LPF circuit 27, to output pulses wherein only the component that is higher than the threshold value is extracted. Note that this threshold value can be a value that is essentially identical to the amplitude, regardless of the light projecting pattern A through C. Of course, the threshold value need not necessarily be a constant, but rather may be modified as appropriate. In the below, the pulse width of the detected light signal that has been demodulated by the LPF circuit 27 and the discriminating circuit 28 shall be termed the "detected light pulse width."

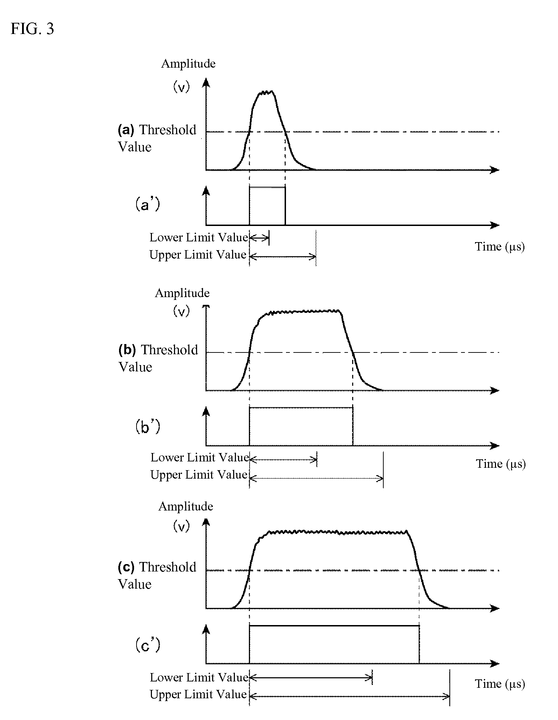

FIG. 3 (a) through the FIG. 3 (c) illustrate detected light signals that are outputted by the LPF circuit 27, and FIG. 3 (a') through FIG. 3 (c') illustrate detected light pulses outputted from the discriminating circuit 28. FIG. 3 (a) and (a') are graphs for the case of the photoelectric switch 1A wherein the light projecting pattern A is selected, FIG. 3 (b) and (b') are graphs for the case of the photoelectric switch 1B wherein the light projecting pattern B is selected, and FIG. 3 (c) and (c') are graphs for the case of the photoelectric switch 1C wherein the light projecting pattern C is selected. Note that interference light is not included in any of these graphs. Because the projected light pulse widths are different in light projecting patterns A through C, when these are demodulated the detected light pulse widths can be different depending on the light projecting pattern, as shown in FIG. 3 (a') through FIG. 3 (c'). Consequently, in the evaluating circuit 29, described below, it is possible to identify the locally-emitted light through an evaluation, in the evaluating circuit 29, described below, as to whether or not the detected light pulse width corresponds to the projected light pulse width of the light projecting pattern that is set in the local device.

The evaluating circuit 29 is provided with a pulse width evaluating circuit 30 and an up/down counter 31. Moreover, it receives, from the pattern selecting portion 21, the light detecting information regarding the detected light pulse width evaluating conditions and the projected light period. The pulse width evaluating circuit 30 evaluates whether or not the detected light pulse width of the detected light signal that is outputted from the discriminating circuit 28 matches the detecting conditions that are indicated by the pattern selecting portion 21, and if so, identifies the locally-emitted light, to output a "1". The evaluating conditions are an upper limit value and a lower limit value for recognizing the pulse width of the locally-emitted light, where the evaluation is that the light is locally-emitted light if the detected light pulse width is greater than or equal to the lower limit value and less than or equal to the upper limit value, where it is evaluated as interference light if outside of the upper/lower limit value range. In the examples in FIG. 3 (a') through FIG. 3 (c'), the evaluations are all that the light is locally-emitted light because the detected light pulse widths are all within the range of the upper and lower limit values.

In an example, the detected light pulse width varies due to variability in the level of the detected luminescent flux quantity relative to the threshold value. If the detected luminescent flux quantity level is slightly higher than the threshold value, then the detected light pulse width will be shorter, but if the detected luminescent flux quantity level is adequately large when compared to the threshold value, then the detected light pulse width will be wider. Because of this, it is necessary to have, in advance, some degree of difference in the projected light pulse width between the patterns so as to be able to discriminate the applicable light projecting pattern A through C, even given variability in the detected light pulse width in the detector 20. Given this, differences of 20 µs are applied between the patterns, as illustrated in FIG. 2, where the projected light pulse width is 8.5 µs in the light projecting pattern A, 28.5 µs in the light projecting pattern B, and 48.5 µs in the light projecting pattern C, to enable discrimination of individual light projecting pattern.

The up/down counter 31 counts up each time there is an "1" outputted from the pulse width evaluating circuit 30, and counts down if the "1" is not outputted for a specific interval of time. In this example, the up/down counter 31 is structured from a digital integrating circuit that performs 10-stage up/down counting. When counting, the prescribed interval is set to an interval that is slightly longer than the projected light period directly after a "1" is inputted (for example, 1.1 times the projected light period), and, thereafter, is set to the same interval as the projected light period. Increasing the length of the interval directly after a "1" is inputted is to eliminate miscounting due to the clock tolerances between the transmitter 10 and the detector 20.

Given this, the evaluating circuit 29 performs the following operations depending on the counter value of the up/down counter 31:
1. If the counter value is 0: Evaluates that there is a blocked-light state (a state wherein there is a detection object).
2. If the counter value is 10: Evaluates that there is an incident-light state (a state wherein there is no detection object).
3. If the counter value is between 1 and 9: Maintains the previous evaluation.

When three photoelectric switches 1 are used together, in an interference state, interference light will become mixed with the locally-emitted light, which may change the detected light pulse width. When this is the case, there will be errors in the evaluations by the pulse width evaluating circuit 30 as to whether or not there is locally-emitted light, but the evaluating circuit 29 performs an evaluating process as to whether or not there is an incident-light state or a blocked-light state, through the up/down counter system, thus making it possible to eliminate some degree of evaluation error by the pulse width evaluating circuit 30. Note that in the case of the 10-stage up/down counter, there can be no recognition error of the incident-light/blocked-light state, in theory, insofar as, on average, the evaluation error is no more than five times. For example, if incorrect evaluations by the pulse width evaluating circuit 30 are produced twice in a row with the counter value of the up/down counter 31 at 10 (that is, if the interval "1" is not outputted for two cycles worth of the projected light period), there can be no incorrect evaluation of the incident-light/blocked-light status if there is no evaluation error thereafter. At this time, the transition of the counter value can be as follows: "10 (incident-light state)" → (evaluation error) → "9 (incident-light state)" → (evaluation error) → "8 (incident-light state)" → "correct evaluation" → "9 (incident-light state) → (correct evaluation) → "10 (incident-light state)", and thus the evaluating circuit 29 will maintain the evaluation that the state is one with incident light. Consequently, the photoelectric switch 1 cannot malfunction.

In this way, if, for example, the counter value is "10", then even if the detected light pulse width evaluation by the pulse width evaluating circuit 30 is not performed correctly, due to noise or interference light, still it is possible to maintain the incident-light state evaluation insofar as the evaluation errors do not continue. Conversely, if the counter value is "0", then even if the detected light pulse width evaluation by the pulse width evaluating circuit 30 is not performed correctly, due to noise or interference light, still the evaluation of the blocked-light state can be maintained insofar as the evaluation errors do not continue. That is, insofar as the counter value does not go from 10 to 0 or from 0 to 10, then it can appear as though the operations are correct even if there are evaluation errors due to interference, thus making it possible to prevent the effects of interferences by suppressing, to no more than some degree, the frequency with which evaluation errors occur in the pulse width evaluating circuit 30 due to mutual interference. In the projected light periods TA through TC, those wherein the ratio of intervals is relatively high can have lower frequencies with which the timing of the projected lights match up. Moreover, if there is an integer ratio of intervals, then because the slower interval may always match the timing of the faster interval, it is necessary for the values to be slightly offset from an integer multiple. Given this, the differences (ratios) between the projected light periods TA through TC are set to values that are slightly larger than 3 times, which are somewhat large values. However, when the ratios between the projected light periods are large, then the response time for the light projecting pattern B can be slower than that of the light projecting pattern A, and the response time for the light projecting pattern C can be even slower than that of the light projecting pattern B, and thus it is desirable to set the projected light periods depending on a balance between the frequency with which evaluation errors occur due to interference and the response time.

Moreover, because the characteristics are such that the response time is slower for the light projecting pattern B than for the light projecting pattern A and slower for the light projecting pattern C than for the light projecting pattern B, preferably the light projecting pattern A is selected if a photoelectric switch 1 is used singly. By the same reasoning, if two photoelectric switches 1 are used together, then preferably the light projecting patterns A and B are selected. Moreover, while the explanation above envisions a maximum of three units installed together, there is no limitation thereto, but rather it is possible to prepare four different light projecting patterns for use in a state wherein four or more photoelectric switches 1 are installed together.

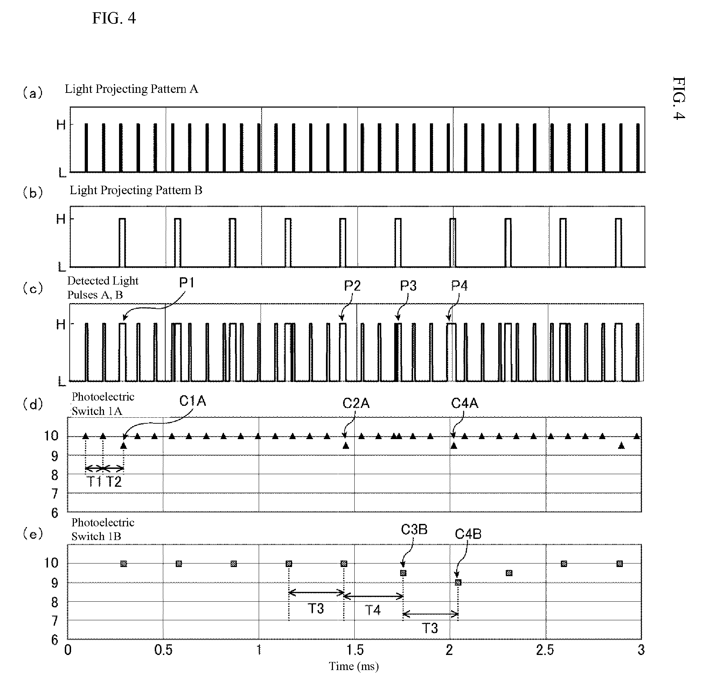

Here FIG. 4 will be used to explain an example of operation in the case wherein two photoelectric switches 1A and 1B according to this first form of embodiment are installed for use together. FIG. 4 (a) is a light signal that is emitted by the light projecting element 15 of the photoelectric switch 1A, and FIG. 4 (b) is a light signal emitted by the light-projecting element 15 of the photoelectric switch 1B. Each of the projected light pulses undergoes high-frequency modulation, but because this is difficult to see in the figure, it is the waveforms prior to the high-frequency modulation that are shown in the graphs. FIG. 4 (c) is the light signal that is detected by the individual light detecting elements 22 of the photoelectric switches 1A and 1B, where they both have identical waveforms due to the mutually interfering state between the projected light of the light projecting patterns A and B. FIG. 4 (d) is the counter value for the up/down counter 31 of the photoelectric switch 1A, and FIG. 4 (e) is the counter value for the up/down counter 31 of the photoelectric switch 1B. Moreover, the horizontal axes in these FIG. 4 (a) through FIG. 4 (d) is time (ms), where the times in each of the graphs is synchronized.

The operation of the photoelectric switch 1A is explained first. The detected light pulse P1 in FIG. 4 (c) has a pulse width that is equal to or greater than the upper limit for the evaluating conditions for the light projecting pattern A because of the state of interference wherein the projected light pulses of the light projecting pattern A are included in the projected light pulses of the light projecting pattern B. Consequently, the pulse width evaluating circuit 30 of the photoelectric switch 1A evaluates the detected light pulse P1 as an interference light (an evaluation error), and the "1" is not be inputted into the up/down counter 31. Here if the period is set to T1, which is the same as the projected light period of the light projecting pattern A, then if a "1" is not inputted into the up/down counter 31 for a period T2 that is slightly longer than this period T1 (for example, T2 = T1 x 1.1), then the counter value counts down from "10" to "9" (C1A in FIG. 4 (d)). When the counter value is "9", the evaluating circuit 29 is set to operate so as to maintain the previous evaluation, and so the evaluation is that there is an incident-light state. The detected light pulses P2 and P4 are also processed identically to the detected light pulse P1.

The detected light pulses that follow these detected light pulses P1, P2, and P4 are evaluated as locally-emitted pulses that fulfill the evaluation conditions because they are near to the projected light pulse widths of the light projecting pattern A, and thus "1" signals are inputted into the up/down counter 31. Consequently, the counter value goes to "10", and so the evaluation is continuously that of an incident-light state.

The operation of the photoelectric switch 1B is explained next. The detected light pulses P1 and P2 of FIG. 4 (c) are those of an interference state wherein the projected light pulses of the light projecting pattern A are included in the projected light pulses of the light projecting pattern B, but because the detected light pulse widths are near to the projected light pulse widths of the light projecting pattern B, the pulse width evaluating circuit 30 of the photoelectric switch 1B evaluates the detected light pulses P1 and P2 as being locally-emitted light, and inputs "1" into the up/down counter 31. Note that the counter value already was at the upper limit of "10", and thus there is no change in the counter value. Because the counter value is "10", the evaluating circuit 29 evaluates that the state is an incident-light state.

The detected light pulse P3 is in an interference state wherein the projected light pulses of the light projecting patterns A and B are partially overlapping, and, more specifically, in the vicinity of the rising edge and in the vicinity of the falling edge of the light projecting interval that is high-frequency modulated in the light projecting pattern B, there is no interference with the light-projecting pattern A, and thus would not be classified as such, but in the vicinity of the center portion of the light projecting interval that is high-frequency modulated in the light projecting pattern B, there is a state wherein there is interference with the light projecting pattern A. In other words, the light projecting pattern B moves from non-interfering to interfering, back to non-interfering. At this time, the BPF circuit 25 acts so as to pass the parts wherein interference does not occur, where, of the light projecting pattern B only those parts that overlap with the light projecting pattern A are attenuated by the BPF circuit 25. Here, in the photoelectric switch 1A, the vicinity of the rising edge and the vicinity of the falling edge of the light projecting interval that is high-frequency modulated in the light projecting pattern B (the non-interfering parts), the lower limit values of the evaluation conditions are not crossed (and, simultaneously, the upper limit values are also not exceeded), so the "1" is inputted twice into the up/down counter 31. In contrast, in the photoelectric switch 1B, the detected light pulse width is equal to or less than the lower limit value for the evaluation conditions, and thus the pulse width evaluating circuit 30 of the photoelectric switch 1B evaluates the detected light pulse P3 as an interference light (an incorrect evaluation), and does not input the "1" into the up/down counter 31. If here the interval that is of the same length as the light projecting interval of the light projecting pattern B is defined as T3, then in the up/down counter 31 the counter value will be counted down from "10" to "9" (FIG. 4 (e) C3B) if there is no "1" input over an interval T4 that is slightly longer than this interval T3 (for example, T4 = T3 x 1.1). At this time, the evaluating circuit 29 will maintain the evaluation that there is an incident-light state. Note that because the detected light pulse width is evaluated only with each projected light pulse period of the light projecting pattern B in the photoelectric switch 1B, even if the two locations (the non-interfering parts) in the vicinity of the rising edge and the vicinity of the falling edge of the projected light interval that undergoes high-frequency modulation in the light projecting pattern B each fall below the lower limit value for the evaluation conditions, the interval of the interaction is adequately short when compared to the projected light pulse period of the light projecting pattern B, so the result is not be the occurrence of two operations that decrement the counter value.

The detected light pulse P4 is an interference state wherein the projected light pulses of the light projecting patterns A and B are continuous, and thus the detected light pulse width is greater than or equal to the evaluation condition for the light projecting pattern B. Because of this, the pulse width evaluating circuit 30 of the photoelectric switch 1B evaluates that the detected light pulse P4 is an interference light (an incorrect evaluation), so does not input the "1" into the up/down counter 31. However, as described above, the up/down counter 31 counts down with an interval T4 that is somewhat longer than the light projecting interval for the next cycle wherein the "1" is inputted (that is, counts down to C3B), to eliminate miscounting due to the tolerance of the clocks. The mismatch due to tolerance error in the clocks can be absorbed in this cycle, restoring normal operations from that cycle forward, making it okay to wait the time interval T3, which is identical to the projected light period, before counting down (that is, the counting down from C3B to C4B).

The subsequent detected light pulse after the detected light pulse P4, and the detected light pulse thereafter, are evaluated as locally-emitted lights because they are equal to the projected light pulse width of the light projecting pattern B, so the "1" is inputted into the up/down counter 31. As a result, the counter value is counted up from "9" to "10", and the evaluation that there is an incident-light state is continued.

In this way, evaluation errors are produced in the evaluation of locally-emitted light versus interference light for the detected light pulses P1, P2, and P4 in the photoelectric switch 1A and evaluation errors for the locally-emitted light versus interference light are produced for the detected light pulses P3 and P4 in the photoelectric switch 1B, but the incident-light state will be maintain insofar as the counter value does not go to "0". Consequently, the occurrence of evaluation errors due to mutual interference between the two photoelectric switches 1A and 1B will occur between 2 and 3 times in 10 evaluations, where if at about this frequency, there will not be a false evaluation of the incident-light/blocked-light status due to these incorrect evaluations.

Given the above, the photoelectric switch 1 is structured through the provision of: a modulating circuit 13 that performs high-frequency modulation of projected light of an appropriate pulse width in accordance with a specific light projecting pattern that is selected, by pattern selecting portions 11 and 21, from three light projecting patterns A through C that each have respectively different projected light periods and projected light pulse widths; a transmitter 10 for performing, for each projected light period, projection of light of the appropriate pulse width, modulated at a high-frequency, toward a detecting region; a BPF circuit 25 for detecting light from the detecting region and extracting a signal having a central frequency that is the modulating frequency used by the modulating circuit 13; a detecting circuit 26 for performing rectification of the signal extracted by the BPF circuit 25; an LPF circuit 27 for reducing, to a prescribed level, the high-frequency component that is superimposed on the signal that has been rectified by the detecting circuit 26; a discriminating circuit 28 for classifying the detected light signal, extracted by the LPF circuit 27, using a prescribed threshold value, and for outputting a detected light pulse; and a pulse width evaluating circuit 30 for evaluating whether or not the pulse width of the detected light pulse, outputted by the discriminating circuit 28, is the same as the projected light pulse width, to evaluate that the light detected by the detector 20 is locally-emitted light, projected by the transmitter 10, if the pulse widths are essentially the same. Because of this, if a maximum of three photoelectric switches 1 are used together, it is possible to identify the locally-emitted light even if there is mutual interference, thus making it possible to evaluate properly an incident-light state versus a blocked-light state.

Note that while in the example the projected light pulse is subjected to high-frequency modulation at 400 kHz by the modulating circuit 13, there is no limitation thereto, but rather the high-frequency modulation need not be performed, as with conventional photoelectric switches. For example, for the light projecting pattern A, light would be projected for 8.5 µs for each projected light period of 90 µs. In the case wherein the high-frequency modulation is not performed, most of the conventional photoelectric switches have frequency characteristics such as the BPF circuit 25 passing the frequency of the projected light period. Consequently, when the projected light pulse width is varied in accordance with the light projecting patterns A through C, the amplitude of the output signal from the BPF circuit 25 will vary greatly depending on the light projecting pattern A through C. Because of this, preferably frequency characteristics are used such that they widen the BPF passing band, so that the amplitudes of the output signals from the BPF circuit 25 does not vary greatly depending on the light projecting pattern A through C. However, this would adversely affect the S/N ratio because the noise that is mixed with the detected light signal would also be passed readily.

In contrast, when the high-frequency modulation is performed as explained above, the BPF circuit 25 is given frequency characteristics so as to pass the frequency of the high-frequency modulation, so that even if the projected light pulse width is changed to 8.5, 28.5, or 48.5 µs depending on the light projecting pattern A through C, still the output signal from the BPF circuit 25 would have essentially the same amplitude. Consequently, through the use of an LPF circuit 27 with frequency characteristics that reduce, to a prescribed level, the high-frequency component that is superimposed through the high-frequency modulation, the differences in the projected light pulse width due to the light projecting pattern can be detected as differences in pulse widths of the detected light signals that have undergone the LPF process.

Moreover, in the example, the evaluating circuit 29 has an up/down counter 31 that increments the counter value when the evaluation by the pulse width evaluating circuit 30 is that there is a locally-emitted light, and that decrements the counter value if there is no subsequent evaluation during an interval over which the light transmitting period of the specific light transmitting pattern essentially elapses since the point in time of that evaluation, and is structured so as to evaluate whether or not there is a detection object in a detecting region based on the counter value of the up/down counter 31. Because of this, even if there is an evaluation error in the pulse width evaluating circuit 30 as to whether there is a mutual interference light or a locally-emitted light, still, if the frequency of the evaluation error is low, it is still possible to prevent a false evaluation as to whether there is an incident-light state or a blocked-light state. Given this, in the example this characteristic of the up/down counter 31 is used to enable a further reduction in false evaluations of the incident-light/blocked-light state through the use of the light projecting patterns A through C by selecting the projected light periods TA through TC so as to reduce the frequency of the evaluation errors regarding whether or not light is locally-emitted light.

Moreover, because in the example the structure is such that it is possible to select the light projecting pattern A through C for each individual photoelectric switch 1 by setting the pattern selecting portions 11 and 21, this enables the user to use photoelectric switches together freely, improving the generalizability and expandability thereof. However, rather than the user selecting a light projecting pattern to set for the photoelectric switch 1, the structure may be one wherein the user sets the light projecting pattern in the photoelectric switch 1 through the inputting a projected light period and a projected light pulse width, or a specific light projecting pattern may be set in the photoelectric switch 1 in advance. If set in advance, then there is no need for the pattern selecting portions 11 and 21.

Note that while there are identical circuit structures, regardless of the light projecting patterns A through C, from the IV converting circuit 23 up through the discriminating circuit 28 for the detector 20 in the example configuration in FIG. 1, there is no limitation thereto, but rather, for example, the structure may be one wherein the frequency characteristics of the LPF circuit 27 are switched depending on the light projecting patterns A through C. Specifically, information for the projected light pulse width depending on the light projecting pattern A through C selected by the pattern selecting portion 21 may be outputted to the LPF circuit 27, to cause the LPF circuit 27 to perform a filtering process that eliminates the high-frequency component that is superimposed through the high-frequency modulation while passing the frequency component for the projected light pulse width, to achieve an improvement in the performance of the photoelectric switch 1.

Moreover, while in the explanation set forth above the explanation was for a case wherein the structure was applied to a transmissive photoelectric switch, there is no limitation thereto, but rather it may be applied to another type of photoelectric switch, such as a reflective type. In other areas as well, the specific structure is not limited to the structure set forth above, but, of course, is included in the present invention even if there are modifications, or the like, in the design within a range that does not deviate from the intent of the present invention.

## Claims

1. A photoelectric switch comprising:
a transmitter (10) following a specific light projecting pattern, from a plurality of light projecting patterns with mutually differing projected light periods and projected light pulse widths, to perform, with each applicable projected light period, light projection of the applicable pulse width toward a detecting region;
a detector (20) detecting light from the detecting region to generate a detected light pulse; and
a pulse width evaluating portion (30) evaluating whether or not a pulse width of the detected light pulse that is produced by the detector is essentially identical to the specific projected light pulse width of the light projecting pattern, to determine, if essentially identical, that light detected by the detector is locally-emitted light projected by the transmitter, **characterized in that** the photoelectric switch further comprises an evaluating portion (29) arranged to, when a locally-emitted light has been identified by the pulse width evaluating portion, add a prescribed number to a count value, and if there is no subsequent identification of a locally-emitted light during an interval from the point of time of that evaluation until the projected light period of the specific light projecting pattern has elapsed, subtract a prescribed value from the count value, to evaluate whether or not there is a detection object in a detecting region based on the count value.

2. A photoelectric switch as set forth in Claim 1, wherein:
the transmitter has a modulating portion for modulating, at a specific frequency, the projected light of the pulse width according to the specific light projecting pattern; and
the detector has:
a band pass filter portion (25) extracting, from a detected light signal, a signal using, as the center frequency, the modulating frequency used by the modulating portion;
a detecting portion (26) rectifying the signal extracted by the band-pass filter portion;
a low-pass filter portion (27) set to a frequency characteristic so as to reduce, to a prescribed level, the frequency component that is superimposed on the signal through the modulation, in the signal that is rectified by the detecting portion; and
a discriminating portion (28) outputting a detected light pulse by discriminating, at a prescribed threshold level, the signal extracted by the low-pass filter portion.

3. A photoelectric switch as set forth in any of Claim 1 or Claim 2, comprising:
a pattern selecting portion receiving an instruction from the outside to select a specific light projecting pattern from a plurality of light projecting patterns.

4. A photoelectric switch as set forth in Claim 2, wherein:
the modulating portion modulates the projected light with a modulating period, wherein the modulation period is structured from a high level interval of approximately 1.0 µs and a low level interval of approximately 1.5 µs.

## Patentansprüche

1. Photoelektrischer Schalter, umfassend:
einen Sender (10) gemäß einem spezifischen Lichtprojektionsmuster aus einer Vielzahl von Lichtprojektionsmustern mit voneinander verschiedenen projizierten Lichtperioden und projizierten Lichtimpulsbreiten, um mit jeder anwendbaren projizierten Lichtperiode eine Lichtprojektion der anwendbaren Impulsbreite hin zu einem Detektionsbereich durchzuführen;
einen Detektor (20), der Licht aus dem Detektionsbereich detektiert, um einen detektierten Lichtimpuls zu erzeugen; und
einen Impulsbreitenwertungsabschnitt (30), der bewertet, ob eine Impulsbreite des detektierten Lichtimpulses, die vom Detektor erzeugt wird, im Wesentlichen identisch mit der spezifischen projizierten Lichtpulsbreite des Lichtprojektionsmusters ist oder nicht, um zu bestimmen, wenn sie im Wesentlichen identisch ist, dass Licht, das vom Detektor detektiert wird, lokal emittiertes Licht ist, das vom Sender projiziert wird,
**dadurch gekennzeichnet, dass** der photoelektrische Schalter weiter einen Bewertungsabschnitt umfasst, der angeordnet ist, um, wenn ein lokal emittiertes Licht durch den Impulsbreiten-Bewertungsabschnitt identifiziert wurde, eine vorgeschriebene Anzahl zu einem Zählwert zu addieren, und, wenn keine folgende Identifizierung eines lokal emittierten Lichts während eines Intervalls von dem Zeitpunkt dieser Bewertung bis die projizierte Lichtperiode des spezifischen Lichtprojektionsmusters abgelaufen ist, vorliegt, einen vorgeschriebenen Wert vom Zählwert zu subtrahieren, um basierend auf dem Zählwert zu bewerten, ob ein Detektionsobjekt in einem Detektionsbereich vorliegt.

2. Photoelektrischer Schalter nach Anspruch 1, wobei der Sender einen Modulationsabschnitt aufweist, um bei einer spezifischen Frequenz das projizierte Licht der Impulsbreite gemäß dem spezifischen Lichtprojektionsmuster zu modulieren; und der Detektor Folgendes aufweist:
einen Bandpassfilterabschnitt (25), der von einem detektierten Lichtsignal ein Signal unter Verwendung, als der zentralen Frequenz, der Modulationsfrequenz, die von dem Modulationsabschnitt verwendet wird, extrahiert;
einen Detektionsabschnitt (26), der das Signal, das vom Bandpassfilterabschnitt extrahiert wurde, gleichrichtet;
einen Tiefpassfilterabschnitt (27), der auf eine Frequenzeigenschaft eingestellt ist, um die Frequenzkomponente die dem Signal durch die Modulation überlagert wird, im Signal, das von dem Detektionsabschnitt gleichgerichtet wird, auf ein vorbestimmtes Niveau zu reduzieren; und
einen Unterscheidungsabschnitt (28), der einen detektierten Lichtimpuls ausgibt, indem er, auf einem vorgeschriebenen Schwellenniveau, das Signal, das vom Tiefpassfilterabschnitt extrahiert wurde, unterscheidet.

3. Photoelektrischer Schalter nach einem von Anspruch 1 oder Anspruch 2, wobei ein Musterauswahlabschnitt eine Anweisung von außen empfängt, um ein spezifisches Lichtprojektionsmuster aus einer Vielzahl von Lichtprojektionsmustern auszuwählen.

4. Photoelektrischer Schalter nach Anspruch 2, wobei
der Modulationsabschnitt das projizierte Licht mit einer Modulationsperiode moduliert, wobei die Modulationsperiode von einem Intervall mit hohem Niveau von ungefähr 1,0 µs und einem Intervall mit niedrigem Niveau von ungefähr 1,5 µs strukturiert ist.

## Revendications

1. Commutateur photoélectrique qui comprend :
un émetteur (10) qui suit un mode de projection de lumière spécifique, parmi une pluralité de modes de projection de lumière qui présentent des périodes de projection de lumière et des durées d'impulsions de projection de lumière mutuellement différentes, afin d'effectuer, avec chaque période de projection de lumière applicable, une projection de lumière vers une zone de détection, avec la durée d'impulsion applicable ;
un détecteur (20) qui détecte la lumière émise par la zone de détection afin de générer une impulsion de lumière détectée ; et
une partie d'évaluation de durée d'impulsion (30) qui évalue si une durée d'impulsion de l'impulsion de lumière détectée qui est produite par le détecteur est essentiellement identique ou non à la durée d'impulsion de projection de lumière spécifique du mode de projection de lumière, de façon à déterminer, si elle est essentiellement identique, que la lumière détectée par le détecteur est une lumière émise localement projetée par l'émetteur, **caractérisé en ce que** le commutateur photoélectrique comprend en outre une partie d'évaluation prévue, lorsqu'une lumière émise localement a été identifiée par la partie d'évaluation de durée d'impulsion, pour ajouter un nombre prescrit à une valeur de décompte, et, en cas d'absence d'identification ultérieure d'une lumière émise localement pendant un intervalle compris entre le moment de ladite évaluation et la fin de la période de projection de lumière selon le mode de projection de lumière spécifique, pour soustraire une valeur prescrite à la valeur de décompte, de façon à évaluer s'il existe ou non un objet de détection dans une zone de détection, sur la base de la valeur de décompte.

2. Commutateur photoélectrique selon la revendication 1, dans lequel :
l'émetteur possède une partie de modulation destinée à moduler, à une fréquence spécifique, la lumière projetée avec la durée d'impulsion propre au mode de projection de lumière spécifique ; et
le détecteur possède :
une partie de filtre passe-bande (25) qui extrait, à partir d'un signal de lumière détecté, un signal qui utilise, comme fréquence centrale, la fréquence de modulation utilisée par la partie de modulation ;
une partie de détection (26) qui rectifie le signal extrait par la partie de filtre passe-bande ;
une partie de filtre passe-bas (27) réglé sur une caractéristique de fréquence de façon à réduire, jusqu'à un niveau prescrit, la composante de fréquence qui est superposée sur le signal par le biais de la modulation, dans le signal qui est rectifié par la partie de détection ; et
une partie de discrimination (28) qui délivre une impulsion de lumière détectée en discriminant, à un niveau de seuil prescrit, le signal extrait par la partie de filtre passe-bas.

3. Commutateur photoélectrique selon l'une quelconque des revendications 1 ou 2, qui comprend :
une partie de sélection de mode qui reçoit une instruction de la part de l'extérieur afin de sélectionner un mode de projection de lumière spécifique parmi une pluralité de modes de projection de lumière.

4. Commutateur photoélectrique selon la revendication 2, dans lequel :
la partie de modulation module la lumière projetée avec une période de modulation, la période de modulation étant structurée entre un intervalle de niveau élevé d'environ 1 µs et un intervalle de niveau faible d'environ 1,5 µs.
